# EUROPEAN PATENT APPLICATION

(11) **EP 4 768 940 A1**
(43) Date of publication of application: **01.07.2026**
(21) Application number: 25745255.7
(22) Date of filing: 24.01.2025
(51) Int. Cl.: G01R 31/374, G01R 31/396, G01R 31/382, G01R 19/165, G01R 19/10, B60L 58/10

(54) **APPARATUS AND METHOD FOR DIAGNOSING BATTERY**

(30) Priority: 26.01.2024 KR 20240012258
(71) Applicant: LG Energy Solution, Ltd., Seoul 07335 (KR)
(72) Inventor: CHOI, Soon-Hyung, Daejeon 34122 (KR); KIM, Dong-Hyun, Daejeon 34122 (KR); KIM, Young-Deok, Daejeon 34122 (KR)
(74) Representative: Goddar, Heinz J.
(86) International application number: PCT/KR2025/001520
(87) International publication number: WO 2025/159589

(57) **Abstract**

A battery diagnosing apparatus according to an embodiment of the present disclosure includes: a profile acquisition unit that acquires a differential profile for a capacity and a voltage of a battery; a profile correction unit that determines a target C-rate (current rate) corresponding to the differential profile, and corrects the differential profile based on an overvoltage profile corresponding to the target C-rate, thereby generating a corrected profile; and a control unit that determines a target peak in the corrected profile, and diagnoses a state of the battery based on a behavior of the determined target peak.

## Description

### TECHNICAL FIELD

This application is based on and claims priority from Korean Patent Application No. 10-2024-0012258, filed on January 26, 2024, with the Korean Intellectual Property Office, the disclosure of which is incorporated herein in its entirety by reference.

The present disclosure relates to a battery diagnosing apparatus and method, more particularly, a battery diagnosing apparatus and method for diagnosing the state of a battery.

### BACKGROUND

Recently, with the rapidly increasing demand for portable electronic products such as notebook computers, video cameras, and portable telephones, and the accelerating development of electric vehicles, energy storage batteries, robots, and satellites, researches on the high-performance batteries allowing repeated charging and discharging are actively underway.

Currently, commercially available batteries include, for example, nickel-cadmium batteries, nickel-hydrogen batteries, nickel-zinc batteries, and lithium batteries. Of these batteries, lithium batteries are gaining considerable attention due to their advantages including a substantially low memory effect to allow a high degree of freedom in charging and discharging, a very low self-discharging rate, and high energy density, as compared to nickel-based batteries.

While many studies are being conducted on the batteries focusing on the high-capacity and the high-density, it is also important to improve the lifespan and the safety of the batteries. In order to enhance the safety of batteries, a technology is necessary, which may accurately diagnose the current state of batteries.

### DISCLOSURE

### Technical Problem

An embodiment of the present disclosure provides a battery diagnosing apparatus and method, which diagnose the current state of a battery in various aspects.

Various aspects of the present disclosure may be understood from the descriptions herein below, and may be more clearly understood from embodiments of the present disclosure. Further, it is readily apparent that various aspects of the present disclosure may be implemented by elements described in the claims and combinations thereof.

### Technical Solution

A battery diagnosing apparatus according to an aspect of the present disclosure may include: a profile acquisition unit that acquires a differential profile for a capacity and a voltage of a battery; a profile correction unit that determines a target C-rate (current rate) corresponding to the differential profile, and corrects the differential profile based on an overvoltage profile corresponding to the target C-rate, thereby generating a corrected profile; and a control unit that determines a target peak in the corrected profile, and diagnoses a state of the battery based on a behavior of the determined target peak.

The profile acquisition unit may be configured to acquire a first differential profile representing a correspondence between the capacity and a differential voltage of the battery.

The profile correction unit may be configured to correct the first differential profile based on a first overvoltage profile, to generate a first corrected profile.

The control unit may be configured to determine, as the target peak, a minimum point with a largest corresponding capacity among minimum points included in the first corrected profile, and diagnose the state of the battery based on a behavior change of the determined target peak.

The control unit may be configured to diagnose that a diffusion resistance of the battery has increased, when a capacity and a differential voltage corresponding to the target peak decreases as a charging and discharging cycle of the battery progresses.

The profile acquisition unit may be configured to acquire a second differential profile representing a correspondence between the voltage and a differential capacity of the battery.

The profile correction unit may be configured to correct the second differential profile based on a second overvoltage profile, to generate a second corrected profile.

The control unit may be configured to determine, a plurality of target peaks, remaining peaks excluding a maximum point with a largest corresponding voltage among maximum points included in the second corrected profile, and diagnose the state of the battery based on a behavior change of the plurality of determined target peaks.

The control unit may be configured to diagnose that an ohmic resistance of the battery has increased, when an amount of change in voltage corresponding to each of the plurality of target peaks falls within a preset first threshold range, and an amount of change in differential capacity corresponding to each of the plurality of target peaks falls within a preset second threshold range, even though a charging and discharging cycle of the battery progresses.

The profile acquisition unit may be configured to further acquire a battery profile corresponding to the capacity and the voltage of the battery.

The control unit may be configured to calculate an amount of voltage drop according to an internal resistance of the battery in the battery profile, and diagnose the state of the battery based on the corrected profile when the calculated amount of voltage drop increases as a charging and discharging cycle of the battery progresses.

The profile correction unit may be configured to calculate a difference between the differential profile and the overvoltage profile to generate the corrected profile.

The overvoltage profile may be pre-stored for each of a plurality of C-rates.

The profile correction unit may be configured to select an overvoltage profile corresponding to the target C-rate from a plurality of pre-stored overvoltage profiles.

The overvoltage profile may be preset based on a reference differential profile of a reference battery for a reference C-rate and a target differential profile of the reference battery for the target C-rate.

The overvoltage profile may be preset to represent a difference between the reference differential profile and the target differential profile.

A battery pack according to another aspect of the present disclosure may include the battery diagnosing apparatus according to an aspect of the present disclosure.

A vehicle according to yet another aspect of the present disclosure may include the battery diagnosing apparatus according to an aspect of the present disclosure.

A battery diagnosing method according to still yet another aspect of the present disclosure may include: a profile acquisition step of acquiring a differential profile for a capacity and a voltage of a battery; a target determination step of determining a target C-rate corresponding to the differential profile; a corrected profile generation step of correcting the differential profile based on an overvoltage profile corresponding to the target C-rate to generate a corrected profile; a target peak determination step of determining a target peak in the corrected profile; and a battery diagnosis step of diagnosing a state of the battery based on a behavior of the determined target peak.

The profile acquisition step may include further acquiring a battery profile representing a correspondence between the capacity and the voltage of the battery.

The battery diagnosing method according to still yet another aspect of the present disclosure may further include, after the profile acquisition step, calculating an amount of voltage drop according to an internal resistance of the battery in the battery profile.

The target determination step may be performed when the amount of voltage drop increases as a charging and discharging cycle of the battery progresses.

A non-transitory computer-readable storage medium according to still yet another aspect of the present disclosure may store therein a program for performing a battery diagnosing method including a profile acquisition step of acquiring a differential profile for a capacity and a voltage of a battery; a target determination step of determining a target C-rate corresponding to the differential profile; a corrected profile generation step of correcting the differential profile based on an overvoltage profile corresponding to the target C-rate to generate a corrected profile; a target peak determination step of determining a target peak in the corrected profile; and a battery diagnosis step of diagnosing a state of the battery based on a behavior of the determined target peak.

### Advantageous Effects

According to an aspect of the present disclosure, the current state of a battery may be diagnosed in various aspects.

According to an aspect of the present disclosure, the state of a battery is diagnosed from a corrected profile, so that the state of the battery may be diagnosed relatively quickly.

The effects of the present disclosure are not limited to those described above, and other effects that are not described herein may clearly be understood to those skilled in the art from the descriptions in the claims.

### BRIEF DESCRIPTION OF THE DRAWINGS

Since the drawings attached herewith serve to facilitate the understanding of the technical idea of the present disclosure in conjunction with the detailed description of the invention herein below, the present disclosure should not be construed as being limited to the matters illustrated in the drawings.
FIG. 1 is a view schematically illustrating a battery diagnosing apparatus according to an embodiment of the present disclosure.
FIG. 2 is a view schematically illustrating a battery profile according to an embodiment of the present disclosure.
FIG. 3 is a view schematically illustrating a first differential profile according to an embodiment of the present disclosure.
FIG. 4 is a view schematically illustrating a second differential profile according to an embodiment of the present disclosure.
FIG. 5 is a view schematically illustrating an overvoltage profile according to an embodiment of the present disclosure.
FIG. 6 is a view schematically illustrating a corrected profile according to an embodiment of the present disclosure.
FIG. 7 is a view schematically illustrating a corrected profile according to an embodiment of the present disclosure.
FIG. 8 is a view schematically illustrating another example of the battery profile according to an embodiment of the present disclosure.
FIG. 9 is a view schematically illustrating a plurality of first corrected profiles according to an embodiment of the present disclosure.
FIG. 10 is a view schematically illustrating a plurality of second corrected profiles according to an embodiment of the present disclosure.
FIG. 11 is a view schematically illustrating a battery pack according to another embodiment of the present disclosure.
FIG. 12 is a view schematically illustrating a vehicle according to yet another embodiment of the present disclosure.
FIG. 13 is a view schematically illustrating a battery diagnosing method according to still yet another embodiment of the present disclosure.

### DETAILED DESCRIPTION

Words and terms used in the detailed description and the claims herein should not be interpreted to be limited to their usual or dictionary meanings, but should be interpreted to have meanings and concepts that correspond to the technical idea of the present disclosure in compliance with the principle that inventors may appropriately define terms and concepts for the purpose of best describing the present disclosure.

Accordingly, it can be appreciated that the embodiments described herein and the configurations illustrated in the drawings are merely examples of the present disclosure, which do not exhaustively represent the technical idea of the present disclosure, and various equivalents and modifications may be made to substitute the present disclosure at the time of filing the present disclosure.

When describing the present disclosure, detailed description of related known configurations or functions may be omitted if determined to obscure the gist of the present disclosure.

Terms with ordinal numbers such as first, second and so on may be used to discriminate one of various components from the other, but should not be interpreted as limiting the components.

Throughout the descriptions herein, when a certain part "includes" a specific component, this description does not indicate that the certain part excludes other components, but indicates that the certain part may further include other components, unless otherwise defined.

Further, throughout the descriptions herein, when two components are "connected" to each other, this description indicates not only that the two components are "directly connected" to each other, but also that the two components are "indirectly connected" to each other via another component.

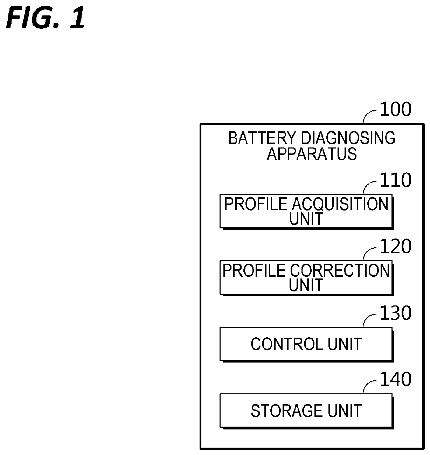

FIG. 1 is a view schematically illustrating a battery diagnosing apparatus 100 according to an embodiment of the present disclosure.

Referring to FIG. 1, the battery diagnosing apparatus 100 may include a profile acquisition unit 110, a profile correction unit 120, a control unit 130, and a storage unit 140.

A battery may indicate a single isolated cell that is physically separable and has a negative electrode terminal and a positive electrode terminal. For example, a lithium-ion battery or a lithium polymer battery may be considered as the battery. The type of battery may be a cylindrical type, a prismatic type, or a pouch type. Further, the battery may indicate a battery bank, a battery module, or a battery pack, in which a plurality of cells is connected to each other in series and/or in parallel. Herein below, for the convenience of description, it is assumed that the battery indicates a single isolated cell.

The profile acquisition unit 110 may be configured to acquire a differential profile for the capacity and the voltage of the battery.

For example, a battery profile BP is a profile representing a correspondence between the voltage (V) and the capacity (Q) when the battery is charged such that the state of charge (SOC) thereof reaches a preset charging termination SOC or 100 % from a preset charging start SOC or 0 %. In another example, the battery profile BP may represent a correspondence between the voltage (V) and the capacity (Q) when the battery is discharged such that the SOC thereof reaches a preset discharging termination SOC or 0 % from a preset discharging start SOC or 100 %.

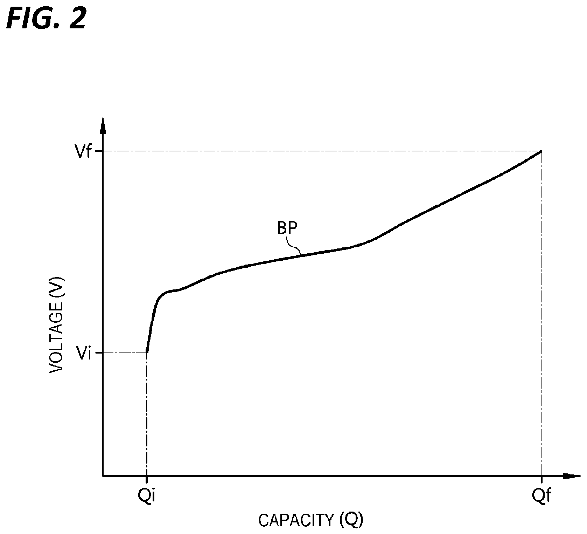

FIG. 2 is a view schematically illustrating the battery profile BP according to an embodiment of the present disclosure. The battery profile BP may be represented as an X-Y graph in which the X axis is set as the capacity (Q), and the Y axis is set as the voltage (V). The voltage range of the battery is Vi to Vf, and the capacity range of the battery is Qi to Qf.

Then, when the battery profile BP is differentiated with respect to the capacity, a differential profile may be generated, which represents a correspondence between the differential voltage (dV/dQ) and the capacity (Q). The differential voltage is a differential value of the voltage with respect to the capacity, and is obtained by differentiating the voltage with respect to the capacity. Hereinafter, the differential profile acquired by differentiating the voltage with respect to the capacity is referred to as a first differential profile DP1.

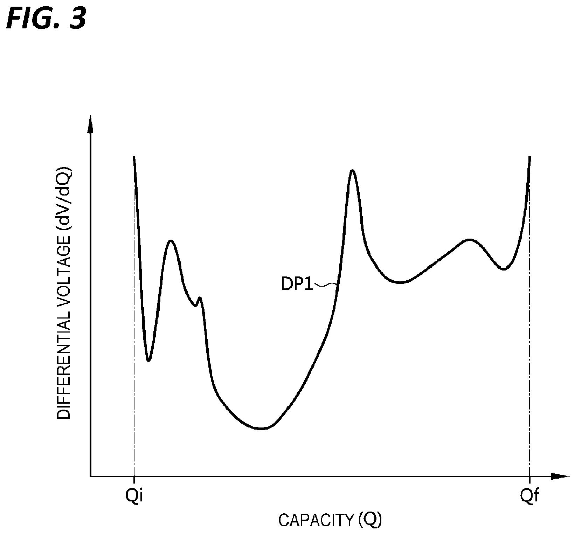

FIG. 3 is a view schematically illustrating the first differential profile DP1 according to an embodiment of the present disclosure. The first differential profile DP1 may be represented as an X-Y graph in which the X axis is set as the capacity (Q), and the Y axis is set as the differential voltage (dV/dQ).

Then, when the battery profile BP is differentiated with respect to the voltage, a differential profile may be generated, which represents a correspondence between the differential capacity (dQ/dV) and the voltage (V). Here, the differential capacity is a differential value of the capacity with respect to the voltage, and is acquired by differentiating the capacity with respect to the voltage. Hereinafter, the differential profile acquired by differentiating the capacity with respect to the voltage is referred to as a second differential profile DP2.

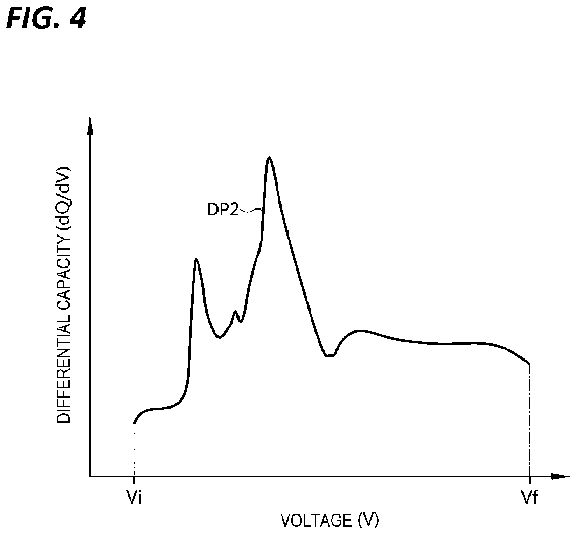

FIG. 4 is a view schematically illustrating the second differential profile DP2 according to an embodiment of the present disclosure. The second differential profile DP2 may be represented as an X-Y graph in which the X axis is set as the voltage (V), and the Y axis is set as the differential capacity (dQ/dV).

For example, the C-rate (current-rate) of the charging or discharging for generating the battery profile BP is not particularly limited. In order to acquire more accurate battery profile BP and differential profile, the battery may be charged or discharged at a low rate. For example, the battery profile BP may be generated during the process of charging or discharging the battery at a low rate such as 0.05 C.

For example, the profile acquisition unit 110 may directly receive the differential profile of the battery from the outside. For example, the profile acquisition unit 110 may acquire the differential profile by being connected to the outside via a wired and/or wireless network to receive the differential profile.

In another example, the profile acquisition unit 110 may directly receive the battery profile BP of the battery from the outside. Then, the profile acquisition unit 110 may generate the differential profile based on the received battery profile BP. For example, the profile acquisition unit 110 may be connected to the outside via a wired and/or wireless network to receive the battery profile BP, and directly generate the differential profile from the received battery profile BP, to acquire the differential profile.

In yet another example, the profile acquisition unit 110 may receive battery information about the voltage and the capacity of the battery. Then, the profile acquisition unit 110 may generate the battery profile BP based on the received battery information, and may generate the differential profile based on the generated battery profile BP. The profile acquisition unit 110 may acquire the differential profile by directly generating the differential profile based on the received battery information.

The profile acquisition unit 110 may be connected to the profile correction unit 120 for a communication. For example, the profile acquisition unit 110 may be connected to the profile correction unit 120 in the wired or wireless manner. The profile acquisition unit 110 may transmit the acquired differential profile to the profile correction unit 120.

The profile correction unit 120 may be configured to determine a target C-rate corresponding to the differential profile.

Further, the profile correction unit 120 may acquire the differential profile and information about the corresponding target C-rate together from the profile acquisition unit 110.

For example, when the battery is charged at 0.33 C, the target C-rate corresponding to the differential profile may be 0.33 C. The profile correction unit 120 may receive the differential profile and information about 0.33 C from the profile acquisition unit 110. Then, the profile correction unit 120 may determine 0.33 C corresponding to the differential profile to be the target C-rate.

The profile correction unit 120 may be configured to correct the differential profile based on an overvoltage profile OP corresponding to the target C-rate, thereby generating a corrected profile CP.

The overvoltage profile OP may be preset to represent an overvoltage portion included in the differential profile. For example, the overvoltage profile OP may be preset based on a reference differential profile of a reference battery for a reference C-rate and a target differential profile of the reference battery for the target C-rate. The target C-rate may be set to be greater than the reference C-rate. According to an embodiment, the overvoltage profile OP may be preset to represent a difference between the reference differential profile and the target differential profile.

For example, in a case where the reference C-rate is 0.05 C and the target C-rate is 0.33 C, a reference battery profile BP for the reference C-rate may be acquired when the reference battery is charged (or discharged) at 0.05 C, and the reference differential profile may be acquired based on the reference battery profile BP. Then, when the reference battery is charged (or discharged) at 0.33 C, a target battery profile BP for the target C-rate may be acquired, and the target differential profile may be acquired based on the target battery profile BP. Then, an overvoltage profile OP corresponding to the C-rate of 0.33 C may be generated according to the difference between the reference differential profile and the target differential profile. When the battery is charged or discharged at the target C-rate greater than the reference C-rate, the measured voltage of the battery may include an overvoltage. Thus, the profile correction unit 120 may remove the reference differential profile based on the reference C-rate from the target differential profile based on the target C-rate, to generate the overvoltage profile OP.

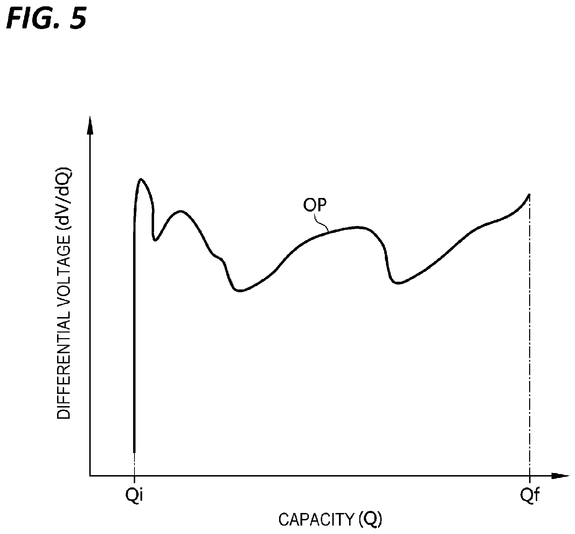

FIG. 5 is a view schematically illustrating the overvoltage profile OP according to an embodiment of the present disclosure. FIG. 5 illustrates the overvoltage profile OP corresponding to the first differential profile DP1.

The overvoltage profile OP according to an embodiment of the present disclosure may be represented as an X-Y graph in which the X axis is set as the capacity, and the Y axis is set as the differential voltage. When the differential profile acquired by the profile acquisition unit 110 is the first differential profile DP1, the overvoltage profile OP may represent the correspondence between the capacity and the differential voltage.

The overvoltage profile OP corresponding to the second differential profile DP2 may be represented as an X-Y graph in which the X axis is set as the voltage, and the Y axis is set as the differential capacity. When the differential profile acquired by the profile acquisition unit 110 is the second differential profile DP2, the overvoltage profile OP may represent the correspondence between the voltage and the differential capacity.

Then, the profile correction unit 120 may be configured to select an overvoltage profile OP corresponding to the target C-rate from a plurality of pre-stored overvoltage profiles OP.

The overvoltage profile OP may be pre-stored for each of a plurality of C-rates.

A plurality of overvoltage profiles OP may be provided, and C-rates corresponding to the plurality of overvoltage profiles OP, respectively, may be different from each other. For example, based on unit C-rates, overvoltage profiles OP corresponding to the C-rates, respectively, may be stored in advance.

Further, an overvoltage profile OP for a C-rate that is not acquired experimentally may be acquired and stored through an interpolation or extrapolation between similar overvoltage profiles OP. For example, the profile correction unit 120 may generate overvoltage profiles OP for various C-rates through the interpolation or extrapolation, in addition to the pre-stored overvoltage profiles OP, and store the generated overvoltage profiles OP in the storage unit 140. For example, when an overvoltage profile OP corresponding to the C-rate of 1 C and an overvoltage profile OP corresponding to the C-rate of 1.2 C are stored in advance, an overvoltage profile OP corresponding to the C-rate of 1.1 C may be further acquired based on the difference between the two overvoltage profiles OP.

The profile correction unit 120 may be configured to calculate the difference between the differential profile and the overvoltage profile OP to generate the corrected profile CP.

For example, the profile correction unit 120 may generate the corrected profile CP by calculating the difference between the differential profile and the overvoltage profile OP in the same way that the overvoltage profile OP is generated according to the difference between the reference differential profile and the target differential profile.

For example, when the differential profile is the first differential profile DP1, the profile correction unit 120 may calculate a differential voltage difference for each capacity between the first differential profile DP1 and the overvoltage profile OP to generate the corrected profile CP.

In another embodiment, when the differential profile is the second differential profile DP2, the profile correction unit 120 may calculate a differential capacity difference for each voltage between the second differential profile DP2 and the overvoltage profile OP to generate the corrected profile CP.

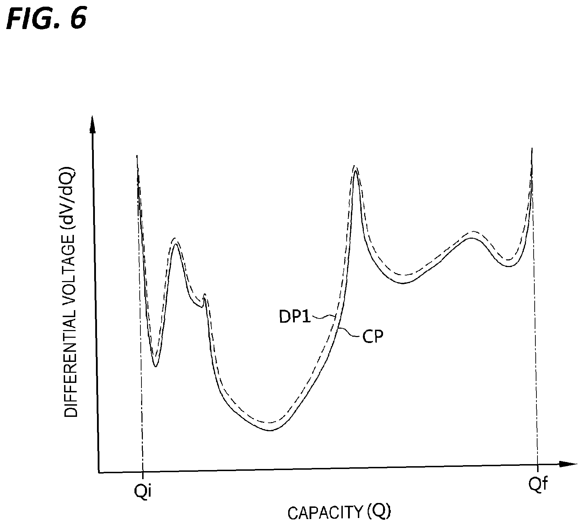

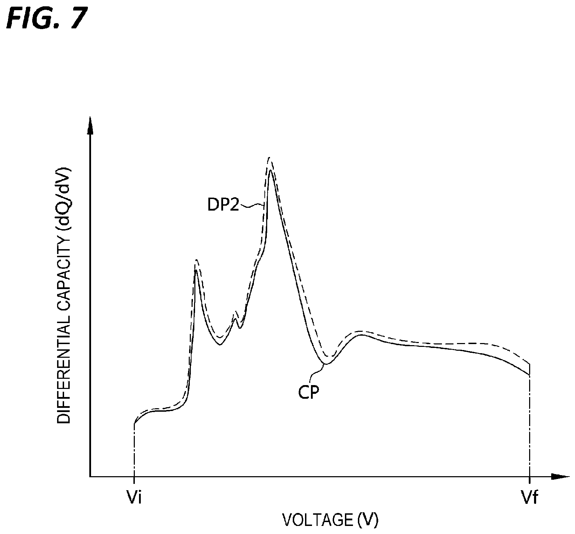

FIGS. 6 and 7 are views schematically illustrating the corrected profile CP according to an embodiment of the present disclosure.

FIG. 6 is a view illustrating the corrected profile CP corresponding to the first differential profile DP1. In the embodiment of FIGS. 5 and 6, the corrected profile CP may be generated according to the differential voltage difference for each capacity between the first differential profile DP1 and the corresponding overvoltage profile OP. The profile correction unit 120 may calculate the difference between the first differential profile DP1 and the overvoltage profile OP, to generate the corrected profile CP in which the overvoltage portion included in the first differential profile DP1 is removed.

FIG. 7 is a view illustrating the corrected profile CP corresponding to the second differential profile DP2. In the embodiment of FIG. 7, the corrected profile CP may be generated according to the differential capacity difference for each voltage between the second differential profile DP2 and the corresponding overvoltage profile (not illustrated). The profile correction unit 120 may calculate the difference between the second differential profile DP2 and the overvoltage profile OP, to generate the corrected profile CP in which the overvoltage portion included in the second differential profile DP2 is removed.

Then, the control unit 130 may determine a target peak in the corrected profile CP, and diagnose the state of the battery based on the behavior of the determined target peak.

The control unit 130 may diagnose whether the internal resistance of the battery increases. When the internal resistance of the battery increases, the control unit 130 may diagnose the cause of the increase in internal resistance. For example, the control unit 130 may diagnose that the increase in internal resistance of the battery is caused from an increase in ohmic resistance (Ro) and/or an increase in diffusion resistance (Rd).

The control unit 130 may diagnose not only whether the internal resistance of the battery increases, but also the cause of the increase in internal resistance of the battery. The control unit 130 may diagnose the current state of the battery in various aspects.

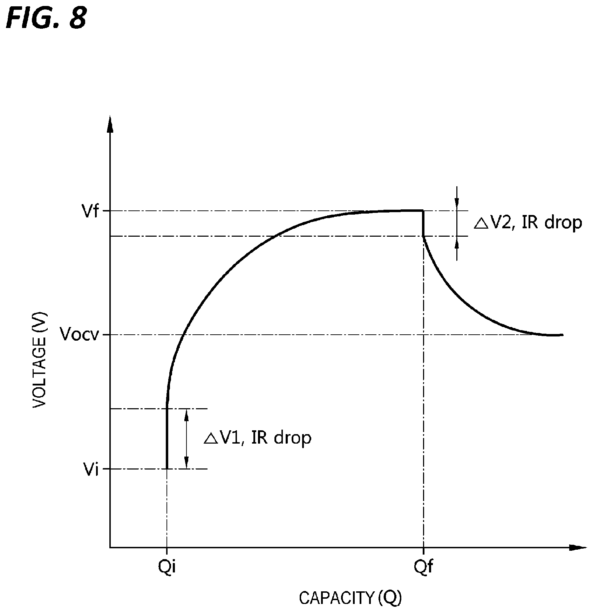

An embodiment where the control unit 130 diagnoses the state of the battery is described herein later with reference to FIGS. 8 to 10.

Further, according to an embodiment of the present disclosure, it is not enforced to charge and discharge the battery at the low C-rate (*e.g.*, 0.05 C) for the purpose of acquiring an accurate differential profile, so that the corrected profile CP in which the overvoltage is removed may be acquired quickly. Further, since the state of the battery is diagnosed from the corrected profile CP, it is advantageous in that the battery diagnosing apparatus 100 may diagnose the state of the battery more quickly.

For example, when the charging and discharging at the low C-rate of 0.05 C are enforced to acquire the battery profile BP, it may take about 20 hours merely to acquire the battery profile BP. Further, additional time may be required to perform a process of converting the acquired battery profile BP into the differential profile and diagnosing the state of the battery according to the differential profile. When the charging and discharging are performed at the low C-rate as described above, a significant amount of time is required to perform the process of acquiring the battery profile BP, which makes it difficult to quickly diagnose the state of the battery.

When the battery is charged and discharged at the C-rate of 0.33 C as in an embodiment of the present disclosure, the battery profile BP may be acquired in about 3 hours. According to an embodiment of the present disclosure, the time required to acquire the battery profile BP may be reduced when the charging and discharging are performed at the C-rate of 0.33 C, as compared to when the charging and discharging are performed at the C-rate of 0.05 C.

The battery profile BP acquired according to an embodiment of the present disclosure includes an overvoltage that corresponds to noise. By calculating a difference between the differential profile and an overvoltage profile OP, the battery diagnosing apparatus 100 may quickly remove noise included in the differential profile. Thus, even further taking into account the time required during the process of generating the corrected profile CP, the battery diagnosing apparatus 100 according to an embodiment of the present disclosure has the advantage of diagnosing the state of the battery relatively very quickly, as compared to the method that enforces the charging and discharging at the low rate.

The profile acquisition unit 110, the profile correction unit 120, and the control unit 130 provided in the battery diagnosing apparatus 100 may selectively include, for example, a processor, an application-specific integrated circuit (ASIC), other chipsets, logic circuits, registers, a communication modem, and a data processing apparatus, which are well-known in the art, in order to execute various control logics performed in the present disclosure. When the control logics are implemented by software, the profile correction unit 120 may be implemented as a set of program modules. In this case, the program modules may be stored in a memory, and executed by the profile acquisition unit 110, the profile correction unit 120, and the control unit 130. The memory may be provided inside or outside the profile acquisition unit 110, the profile correction unit 120, and the control unit 130, and may be connected to the profile acquisition unit 110, the profile correction unit 120, and the control unit 130 by various well-known means.

The battery diagnosing apparatus 100 may further include the storage unit 140. The storage unit 140 may store, for example, data or programs necessary when each component of the battery diagnosing apparatus 100 performs the operation and function thereof, or data generated when the operation and function are performed. The storage unit 140 is not particularly limited in type as long as it is a well-known information storage means capable of recording, erasing, updating, and reading data. The information storage means may include, for example, a random access memory (RAM), a flash memory, a read-only memory (ROM), an electronically erasable programmable read-only memory (EEPROM), and a register. Further, the storage unit 140 may store program codes, in which processes executable by the profile acquisition unit 110, the profile correction unit 120, and the control unit 130 are defined. Further, the storage unit 140 may store the battery profile BP, the differential profiles DP1 and DP2, the overvoltage profile OP, and the corrected profile CP.

In an embodiment, the profile acquisition unit 110 may be configured to acquire the first differential profile DP1 representing the correspondence between the capacity and the differential voltage. The profile correction unit 120 may be configured to correct the first differential profile DP1 based on the first overvoltage profile OP, to generate a first correction profile CP. Here, the first differential profile DP1, the first overvoltage profile OP, and the first correction profile CP may represent the correspondence between the capacity and the differential voltage.

In another embodiment, the profile acquisition unit 110 may be configured to acquire the second differential profile DP2 representing the correspondence between the voltage and the differential capacity. The profile correction unit 120 may be configured to correct the second differential profile DP2 based on the second overvoltage profile OP, to generate a second correction profile CP. Here, the second differential profile DP2, the second overvoltage profile OP, and the second correction profile CP may represent the correspondence between the voltage and the differential capacity.

Since the difference between the differential profile and the overvoltage profile OP should be calculated in order to generate the corrected profile CP, the differential profile and the overvoltage profile OP may have the same format.

When the differential profile represents the correspondence between the capacity and the differential voltage, the overvoltage profile OP may also represent the correspondence between the capacity and the differential voltage. When the differential profile represents the correspondence between the voltage and the differential capacity, the overvoltage profile OP may also represent the correspondence between the voltage and the differential capacity.

For example, referring to FIGS. 3, 5, and 6, the first differential profile DP1 and the overvoltage profile OP represent the correspondence between the capacity and the differential voltage. Thus, the profile correction unit 120 may calculate the differential voltage difference for each capacity between the first differential profile DP1 and the overvoltage profile OP, to generate the corrected profile CP.

Hereinafter, descriptions will be made on an embodiment where the control unit 130 diagnoses the state of the battery.

The control unit 130 may first consider an amount of voltage drop in the battery, to determine whether to diagnose the state of the battery. The control unit 130 may determine the necessity for diagnosing the state of the battery based on the amount of voltage drop in the battery.

The profile acquisition unit 110 may be configured to further acquire a battery profile BP corresponding to the capacity and the voltage of the battery.

FIG. 8 is a view schematically illustrating another example of the battery profile BP according to an embodiment of the present disclosure. The battery profile BP may be represented as an X-Y graph in which the X axis is set as the capacity, and the Y axis is set as the voltage. The battery profile BP of FIG. 8 represents the amount of voltage drop (ΔV) at each of the start time point and the end time point of the charging.

Since the battery includes the internal resistance, an IR drop (*e.g.*, voltage drop) occurs at the start time point and the end time point of the charging. The IR drop may result from the influence of the ohmic resistance and the diffusion resistance. Similarly, the IR drop also occurs at the start time point and the end time point of the discharging.

The control unit 130 may be configured to calculate the amount of voltage drop according to the internal resistance of the battery in the battery profile BP.

For example, when the battery profile BP corresponds to a charging profile of the battery, the control unit 130 may calculate the amount of voltage drop at the start time point and/or the end time point of the charging. In another example, when the battery profile BP corresponds to a discharging profile of the battery, the control unit 130 may calculate the amount of voltage drop at the start time point and/or the end time point of the discharging.

For example, in the embodiment of FIG. 8, the control unit 130 may calculate the amount of voltage drop at the initial time point of the charging as △V1 [V]. In another example, the control unit 130 may calculate the amount of voltage drop at the end time point of the charging as △V2 [V]. In yet another example, the control unit 130 may calculate the summed amount of voltage drop (△V1 [V]) at the start time point of the charging and voltage drop (△V2 [V]) at the end time point of the charging (△V1+ΔV2).

The control unit 130 may be configured to diagnose the state of the battery based on the corrected profile CP when the calculated amount of voltage drop increases as the charging and discharging cycle of the battery progresses.

For example, the control unit 130 may determine whether the amount of voltage drop increases, by considering the variation of the amount of voltage drop in accordance with the charging and discharging cycle of the battery. Since the amount of voltage drop is a factor proportional to the internal resistance, the increase in amount of voltage drop with the progress of the charging and discharging cycle of the battery may indicate that the internal resistance of the battery is increasing. When the amount of voltage drop increases as the charging and discharging cycle of the battery progresses, the control unit 130 may diagnose that the internal resistance of the battery has increased. Then, the control unit 130 may determine that it is necessary to diagnose the cause of the internal resistance of the battery.

When the amount of voltage drop does not increase even though the charging and discharging cycle of the battery progresses, it may indicate that the internal resistance of the battery is not increasing, and the control unit 130 may determine that it is unnecessary to diagnose the state of the battery.

According to an embodiment, the control unit 130 may diagnose the state of the battery only when the diagnosis of the state of the battery is necessary, so that the system resources required to diagnose the state of the battery may be saved.

Hereinafter, descriptions will be made on an embodiment where the amount of voltage drop gradually increases as the charging and discharging cycle of the battery progresses, and thus, the control unit 130 diagnoses the state of the battery.

First, an embodiment will be described, in which the control unit 130 diagnoses the state of the battery based on the first corrected profile CP.

The control unit 130 may be configured to determine, as a target peak, a minimum point with the largest corresponding capacity among minimum points included in the first corrected profile CP.

The first corrected profile CP is a profile generated based on the first differential profile and the overvoltage profile OP. The control unit 130 may determine, as a target peak, a minimum point with the largest corresponding capacity among a plurality of minimum points included in the first corrected profile CP.

The control unit 130 may be configured to diagnose the state of the battery based on the behavior change of the determined target peak.

The first corrected profile CP may be generated in each of a plurality of charging and discharging cycles of the battery, and the target peak may be determined in each of the plurality of first corrected profiles CP. A plurality of target peaks corresponding to the plurality of charging and discharging cycles of the battery may be determined. According to an embodiment, the control unit 130 may diagnose the state of the battery by considering the behavior change of the plurality of target peaks over time.

For example, the control unit 130 may be configured to diagnose that the diffusion resistance of the battery has increased, when the capacity and the differential voltage corresponding to the target peak decrease as the charging and discharging cycle of the battery progresses. Alternatively, the control unit 130 may diagnose that the diffusion resistance of the battery has increased, when the capacity and the differential voltage corresponding to the target peak decrease as the battery degrades.

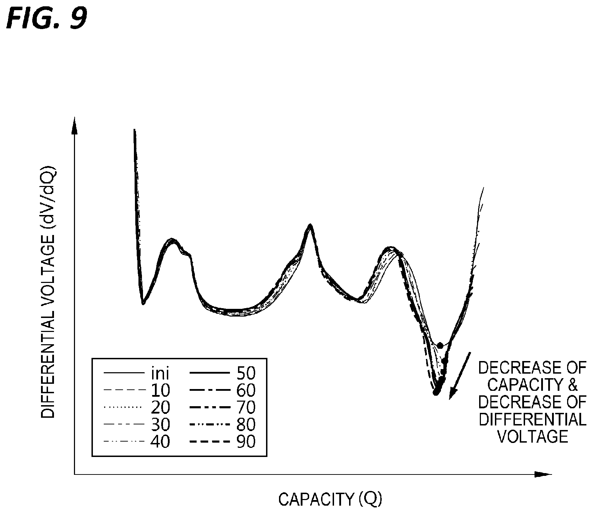

FIG. 9 is a view schematically illustrating the plurality of first corrected profiles CP according to an embodiment of the present disclosure. The plurality of first corrected profiles CP include first corrected profiles CP determined in an initial cycle "ini," a 10th cycle, a 20th cycle, a 30th cycle, a 40th cycle, a 50th cycle, a 60th cycle, a 70th cycle, an 80th cycle, and a 90th cycle.

In the embodiment of FIG. 9, the point indicated by the symbol **"•"** corresponds to the target peak. Since the capacity and the differential voltage corresponding to the target peak gradually decrease as the charging and discharging cycle of the battery progresses, the control unit 130 may diagnose that the diffusion resistance of the battery has increased. The control unit 130 may diagnose that the internal resistance of the battery has increased from the initial state, and the increase in internal resistance is caused from the increase in diffusion resistance.

Next, descriptions will be made on an embodiment where the control unit 130 diagnoses the state of the battery based on the second corrected profile CP.

The control unit 130 may be configured to determine, as a plurality of target peaks, remaining maximum points excluding a maximum point with the largest corresponding voltage among maximum points included in the second corrected profile CP.

The second corrected profile CP is a profile generated based on the second differential profile and the overvoltage profile OP. The control unit 130 may be configured to determine, as target peaks, remaining maximum points excluding a maximum point with the largest corresponding voltage among a plurality of maximum points included in the second corrected profile CP. The control unit 130 may determine a plurality of target peaks in the second corrected profile CP.

The control unit 130 may be configured to diagnose the state of the battery based on the behavior change of the plurality of determined target peaks.

The second corrected profile CP may be generated in each of the plurality of charging and discharging cycles of the battery, and the plurality of target peaks may be determined in the plurality of second corrected profiles CP, respectively. A plurality of target peaks corresponding to the plurality of cycles, respectively, may be determined. According to an embodiment, the control unit 130 may diagnose the state of the battery by considering the behavior change among the plurality of corresponding target peaks over time.

For example, the control unit 130 may determine a first target peak, a second target peak, and a third target peak in an order of voltage in the second corrected profile CP. For example, a plurality of first target peaks, a plurality of second target peaks, and a plurality of third target peaks may be determined for the plurality of second corrected profiles CP. The control unit 130 may diagnose the state of the battery based on the behavior change of the plurality of first target peaks over time, the behavior change of the plurality of second target peaks over time, and the behavior change of the plurality of third target peaks over time.

The control unit 130 may be configured to diagnose that the ohmic resistance of the battery has increased, when the amount of change in voltage corresponding to each of the plurality of target peaks falls within a preset first threshold range, and the amount of change in differential capacity corresponding to each of the plurality of target peaks falls within a preset second threshold range, even though the charging and discharging cycle of the battery progresses.

The first threshold range is a preset voltage range in which the amount of change in voltage may be determined to be a certain level or less. For example, when the amount of change in voltages of the plurality of target peaks falls within the first threshold range even though the voltages of the target peaks increase or decrease according to the charging and discharging cycle of the battery, the control unit 130 may determine the change in voltages of the plurality of target peaks to be the certain level or less.

The second threshold range is a preset differential capacity range in which the amount of change in differential capacity may be determined to be a certain level or less. For example, when the change in differential capacities of the plurality of target peaks falls within the second threshold range even though the differential capacities of the target peaks increase or decrease according to the charging and discharging cycle of the battery, the control unit 130 may determine the change in differential capacities of the plurality of target peaks to be the certain level or less.

When the behavior change of the plurality of target peaks is the certain level or less even though the battery degrades, the control unit 130 may diagnose that the ohmic resistance of the battery has increased. When the behavior change among the plurality of corresponding target peaks over time is the certain level or less, the control unit 130 may diagnose that the ohmic resistance of the battery has increased.

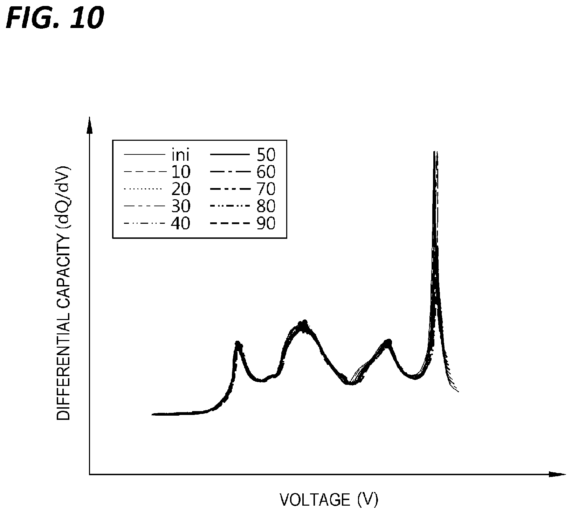

FIG. 10 is a view schematically illustrating the plurality of second corrected profiles CP according to an embodiment of the present disclosure. The plurality of second corrected profiles CP include second corrected profiles CP determined in the initial cycle "ini," the 10th cycle, the 20th cycle, the 30th cycle, the 40th cycle, the 50th cycle, the 60th cycle, the 70th cycle, the 80th cycle, and the 90th cycle.

In the embodiment of FIG. 10, the point indicated by the symbol **"•"** corresponds to the target peak. The symbol "□" indicates the plurality of corresponding target peaks. While the charging and discharging cycle of the battery progresses, the voltages and the differential capacities of the plurality of corresponding target peaks are maintained at the certain level or less. In the embodiment of FIG. 10, the amount of change in voltages of the plurality of corresponding target peaks falls within the first threshold range, and the amount of change in differential capacities thereof falls within the second threshold range. Thus, the control unit 130 may diagnose that the ohmic resistance of the battery is increasing. The control unit 130 may diagnose that the internal resistance of the battery has increased from the initial state, and the increase in internal resistance is caused from the increase in ohmic resistance.

The control unit 130 may diagnose the cause of the increase in internal resistance of the battery by considering both the first corrected profile CP and the second corrected profile CP.

For example, the control unit 130 may diagnose that the increase in internal resistance of the battery is caused from the increase in ohmic resistance and/or the increase in diffusion resistance.

The battery diagnosing apparatus 100 according to the present disclosure may be applied to a battery management system (BMS). For example, a BMS according to the present disclosure may include the battery diagnosing apparatus 100 described above. In this configuration, at least a portion of the respective components of the battery diagnosing apparatus 100 may be implemented by complementing or adding functions of components included in well-known BMSs. For example, the profile acquisition unit 110, the profile correction unit 120, the control unit 130, and the storage unit 140 of the battery diagnosing apparatus 100 may be implemented as components of the BMS.

Further, the battery diagnosing apparatus 100 according to the present disclosure may be provided in a battery pack. For example, the battery pack according to the present disclosure may include the battery diagnosing apparatus 100 described above and one or more battery cells. Further, the battery pack may include, for example, electrical components (*e.g*., relays and fuses) and a case.

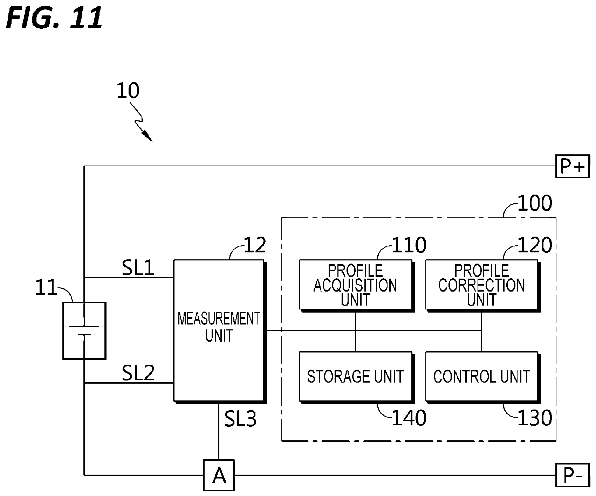

FIG. 11 is a view schematically illustrating a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measurement unit 12 may be connected to a first sensing line SL1, a second sensing line SL2, and a third sensing line SL3. The measurement unit 12 may be connected to the positive electrode terminal of the battery 11 via the first sensing line SL1, and may be connected to the negative electrode terminal of the battery 11 via the second sensing line SL2. The measurement unit 12 may measure the voltage of the battery 11 based on the voltage measured in each of the first sensing line SL1 and the second sensing line SL2.

The measurement unit 12 may be connected to a current measuring unit A via the third sensing line SL3. For example, the current measuring unit A may be an ammeter or a shunt resistor capable of measuring a charging current and a discharging current of the battery 11. The measurement unit 12 may measure the charging current of the battery 11 through the third sensing line SL3 to calculate a charging amount. Further, the measurement unit 12 may measure the discharging current of the battery 11 through the third sensing line SL3 to calculate a discharging amount.

For example, the profile acquisition unit 110 may receive the battery information about the voltage and the current of the battery from the measurement unit 12. Then, the profile acquisition unit 110 may generate the battery profile BP and the differential profile based on the battery information.

In another example, the profile acquisition unit 110 may receive the battery profile BP from the measurement unit 12. Then, the profile acquisition unit 110 may generate the differential profile based on the battery profile BP.

In yet another example, the profile acquisition unit 110 may receive the differential profile from the measurement unit 12.

An external device may be connected to the positive electrode terminal P+ and the negative electrode terminal P- of the battery pack 10. For example, the external device may be a charging device or a load. The positive electrode terminal of the battery 11, the positive electrode terminal P+ of the battery pack 10, the external device, the negative electrode terminal P- of the battery pack 10, and the negative electrode terminal of the battery 11 may be electrically connected to each other.

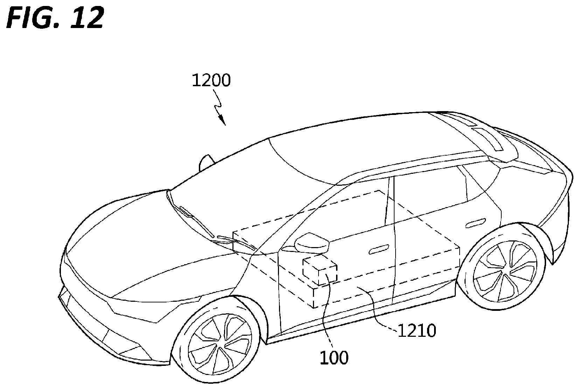

FIG. 12 is a view schematically illustrating a vehicle 1200 according to yet another embodiment of the present disclosure.

Referring to FIG. 12, the battery pack according to an embodiment of the present disclosure may be included in the vehicle 1200 such as an electric vehicle (EV) or a hybrid vehicle (HV). A battery pack 1210 may supply a power to a motor via an inverter provided in the vehicle 1200, to drive the vehicle 1200. Here, the battery pack 1210 may include the battery diagnosing apparatus 100. For example, the vehicle 1200 may include the battery diagnosing apparatus 100. In this case, the battery diagnosing apparatus 100 may be an on-board apparatus included in the vehicle 1200.

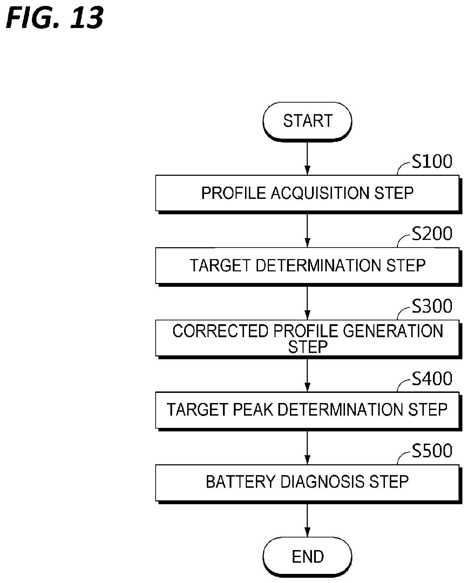

FIG. 13 is a view schematically illustrating a battery diagnosing method according to still yet another embodiment of the present disclosure.

Referring to FIG. 13, the battery diagnosing method may include a profile acquisition step S100, a target determination step S200, a corrected profile generation step S300, a target peak determination step S400, and a battery diagnosis step S500.

Each step of the battery diagnosing method may be performed by the battery diagnosing apparatus 100.

The profile acquisition step S100 is a step of acquiring the differential profile representing the correspondence between the capacity and the differential voltage of the battery or between the voltage and the differential capacity of the battery, and may be performed by the profile acquisition unit 110.

For example, the profile acquisition unit 110 may directly receive the differential profile of the battery from the outside. For example, the profile acquisition unit 110 may acquire the differential profile by being connected to the outside via a wired and/or wireless network to receive the differential profile.

In another example, the profile acquisition unit 110 may directly receive the battery profile BP of the battery from the outside. Then, the profile acquisition unit 110 may generate the differential profile DP based on the received battery profile BP. The profile acquisition unit 110 may be connected to the outside via a wired and/or wireless network to receive the battery profile BP, and directly generate the differential profile from the received battery profile BP, to acquire the differential profile.

In yet another example, the profile acquisition unit 110 may receive the battery information about the voltage and the capacity of the battery. Then, the profile acquisition unit 110 may generate the battery profile BP based on the received battery information, and may generate the differential profile based on the generated battery profile BP. The profile acquisition unit 110 may acquire the differential profile by directly generating the differential profile based on the received battery information.

The target determination step S200 is a step of determining the target C-rate corresponding to the differential profile, and may be performed by the profile correction unit 120.

For example, the profile correction unit 120 may receive the differential profile and information about the C-rate from the profile acquisition unit 110. Then, the profile correction unit 120 may determine the C-rate corresponding to the differential profile to be the target C-rate.

The corrected profile generation step S300 is a step of correcting the differential profile based on the overvoltage profile OP corresponding to the target C-rate, to generate the corrected profile CP.

Then, the profile correction unit 120 may be configured to select the overvoltage profile OP corresponding to the target C-rate from a plurality of pre-stored overvoltage profiles. The profile correction unit 120 may be configured to calculate the difference between the differential profile and the overvoltage profile OP to generate the corrected profile CP.

For example, when the differential profile is the first differential profile DP1, the profile correction unit 120 may calculate a differential voltage difference for each capacity between the first differential profile DP1 and the overvoltage profile OP to generate the corrected profile CP.

In another example, when the differential profile is the second differential profile DP2, the profile correction unit 120 may calculate a differential capacity difference for each voltage between the second differential profile DP2 and the overvoltage profile OP to generate the corrected profile CP.

The target peak determination step S400 is a step of determining a target peak in the corrected profile CP, and may be performed by the control unit 130.

For example, the control unit 130 may be configured to determine, as a target peak, a minimum point with the largest corresponding capacity among minimum points included in the first corrected profile CP.

In another example, the control unit 130 may be configured to determine, as a plurality of target peaks, remaining maximum points excluding a maximum point with the largest corresponding voltage among maximum points included in the second corrected profile CP.

The battery diagnosis step S500 is a step of diagnosing the state of the battery based on the behavior of the determined target peak, and may be performed by the control unit 130.

For example, the control unit 130 may be configured to diagnose that the diffusion resistance of the battery has increased, when the capacity and the differential voltage corresponding to the target peak determined from the first corrected profile CP decreases as the cycle progresses.

In another example, the control unit 130 may be configured to diagnose that the ohmic resistance of the battery has increased, when the amount of change in voltage corresponding to each of the plurality of target peaks determined from the second corrected profile CP falls within the preset first threshold range, and the amount of change in corresponding differential capacity falls within the preset second threshold range, even though the cycle progresses.

The battery diagnosing method according to still yet another embodiment of the present disclosure may further include a voltage drop amount calculation step (not illustrated).

In the profile acquisition step S100, the profile acquisition unit 110 may further acquire the battery profile BP representing the correspondence between the capacity and the voltage of the battery.

The voltage drop amount calculation step is a step of calculating the amount of voltage drop according to the internal resistance of the battery in the battery profile, and may be performed by the control unit after the profile acquisition step S100.

Then, the control unit 130 may be configured to diagnose the state of the battery based on the corrected profile CP, when the calculated amount of voltage drop increases as the charging and discharging cycle of the battery progresses. For example, in order to reduce the consumption of system resources required to diagnose the state of the battery, the target determination step S200, the corrected profile generation step S300, the target peak determination step S400, and the battery diagnosis step S500 may be performed when the amount of voltage drop of the battery increases as the charging and discharging cycle of the battery progresses.

The embodiments of the present disclosure described above are not only implemented by an apparatus and method, but may also be implemented by programs implementing functions corresponding to the components of the embodiments of the present disclosure or a recording medium that stores the programs. This implementation may readily be achieved by one skilled in the art to which the present disclosure belongs, from the descriptions of the embodiments above.

While the present disclosure has been described using limited embodiments and drawings, the present disclosure is not limited thereto, and it may be appreciated that various modifications and changes may be made by those having ordinary skill in the art of the present disclosure within the technical idea of the present disclosure and the equitable scope of the claims set forth below.

Further, since various substitutions, modifications, and changes may be made by those having ordinary skill in the art of the present disclosure within the scope that does not depart from the technical idea of the present disclosure, the present disclosure described above is not limited by the foregoing embodiments and the accompanying drawings, but all or portions of the embodiments may be selectively combined to implement various modifications.

### (Description of Symbols)

10: battery pack
11: battery
12: measurement unit
100: battery diagnosing apparatus
110: profile acquisition unit
120: profile storage unit
130: control unit
140: storage unit
1200: vehicle
1210: battery pack

## Claims

1. A battery diagnosing apparatus comprising:
a profile acquisition unit configured to acquire a differential profile for a capacity and a voltage of a battery;
a profile correction unit configured to determine a target C-rate (current rate) corresponding to the differential profile, and correct the differential profile based on an overvoltage profile corresponding to the target C-rate, thereby generating a corrected profile; and
a control unit configured to determine a target peak in the corrected profile, and diagnose a state of the battery based on a behavior of the determined target peak.

2. The battery diagnosing apparatus according to claim 1, wherein the profile acquisition unit is configured to acquire a first differential profile representing a correspondence between the capacity and a differential voltage of the battery, and
the profile correction unit is configured to correct the first differential profile based on a first overvoltage profile, to generate a first corrected profile.

3. The battery diagnosing apparatus according to claim 2, wherein the control unit is configured to determine, as the target peak, a minimum point with a largest corresponding capacity among minimum points included in the first corrected profile, and diagnose the state of the battery based on a behavior change of the determined target peak.

4. The battery diagnosing apparatus according to claim 3, wherein the control unit is configured to diagnose that a diffusion resistance of the battery has increased, when a capacity and a differential voltage corresponding to the target peak decreases as a charging and discharging cycle of the battery progresses.

5. The battery diagnosing apparatus according to claim 1, wherein the profile acquisition unit is configured to acquire a second differential profile representing a correspondence between the voltage and a differential capacity of the battery, and
the profile correction unit is configured to correct the second differential profile based on a second overvoltage profile, to generate a second corrected profile.

6. The battery diagnosing apparatus according to claim 5, wherein the control unit is configured to determine, a plurality of target peaks, remaining peaks excluding a maximum point with a largest corresponding voltage among maximum points included in the second corrected profile, and diagnose the state of the battery based on a behavior change of the plurality of determined target peaks.

7. The battery diagnosing apparatus according to claim 6, wherein the control unit is configured to diagnose that an ohmic resistance of the battery has increased, when an amount of change in voltage corresponding to each of the plurality of target peaks falls within a preset first threshold range, and an amount of change in differential capacity corresponding to each of the plurality of target peaks falls within a preset second threshold range, even though a charging and discharging cycle of the battery progresses.

8. The battery diagnosing apparatus according to claim 1, wherein the profile acquisition unit is configured to further acquire a battery profile corresponding to the capacity and the voltage of the battery, and
the control unit is configured to calculate an amount of voltage drop according to an internal resistance of the battery in the battery profile, and diagnose the state of the battery based on the corrected profile when the calculated amount of voltage drop increases as a charging and discharging cycle of the battery progresses.

9. The battery diagnosing apparatus according to claim 1, wherein the profile correction unit is configured to calculate a difference between the differential profile and the overvoltage profile to generate the corrected profile.

10. The battery diagnosing apparatus according to claim 1, wherein the overvoltage profile is pre-stored for each of a plurality of C-rates, and
the profile correction unit is configured to select an overvoltage profile corresponding to the target C-rate from a plurality of pre-stored overvoltage profiles.

11. The battery diagnosing apparatus according to claim 1, wherein the overvoltage profile is preset based on a reference differential profile of a reference battery for a reference C-rate and a target differential profile of the reference battery for the target C-rate.

12. The battery diagnosing apparatus according to claim 11, wherein the overvoltage profile is preset to represent a difference between the reference differential profile and the target differential profile.

13. A battery pack comprising the battery diagnosing apparatus according to any one of claims 1 to 12.

14. A vehicle comprising the battery diagnosing apparatus according to any one of claims 1 to 12.

15. A battery diagnosing method comprising:
a profile acquisition step of acquiring a differential profile for a capacity and a voltage of a battery;
a target determination step of determining a target C-rate corresponding to the differential profile;
a corrected profile generation step of correcting the differential profile based on an overvoltage profile corresponding to the target C-rate to generate a corrected profile;
a target peak determination step of determining a target peak in the corrected profile; and
a battery diagnosis step of diagnosing a state of the battery based on a behavior of the determined target peak.
